# EUROPEAN PATENT APPLICATION

(11) **EP 3 962 245 A1**
(43) Date of publication of application: **02.03.2022**
(21) Application number: 20837374.6
(22) Date of filing: 21.04.2020
(51) Int. Cl.: H05K 3/32, H05K 3/00, H05K 13/04, B05B 17/06

(54) **MANUFACTURING PROCESS FOR ULTRASONIC ATOMIZATION SHEET**

(30) Priority: 10.07.2019 CN 201910622009
(71) Applicant: Shenzhen Shang Jin Electronic Science and Technology Co. Ltd., Shenzhen, Guangdong 518100 (CN)
(72) Inventor: ZHENG, Yao, Shenzhen, Guangdong 518100 (CN); SU, Qiuhong, Shenzhen, Guangdong 518100 (CN); SU, Songwan, Shenzhen, Guangdong 518100 (CN)
(74) Representative: Lin Chien, Mon-Yin
(86) International application number: PCT/CN2020/085845
(87) International publication number: WO 2021/004117

(57) **Abstract**

A manufacturing process for ultrasonic atomization piece relates to the atomization piece technical field and includes: S1. cutting a press-thermosetting conductive adhesive film into a shape matched with a piezoelectric ceramic sheet; S2. placing the press-thermosetting conductive adhesive film on a composite plate, wherein the composite plate includes a substrate and a conductive layer, the press-thermosetting conductive adhesive film is placed on the conductive layer, and the substrate is a polymer film; S3. placing the piezoelectric ceramic sheet on the press-thermosetting conductive adhesive film; S4. pressing the piezoelectric ceramic sheet and the composite plate in S3 together by a press machine. The press-thermosetting conductive adhesive film for connecting the piezoelectric ceramic sheet and the composite plate can be cured in a short time under high pressure and heating and has excellent adhesion, which is a thin film material with excellent plasticity and can be easily cut into various shapes.

## Description

### TECHNICAL FIELD

The present disclosure relates to the technical field of atomization piece, and in particular to a manufacturing process for ultrasonic atomization piece.

### RELATED ART

An ultrasonic atomization piece breaks up a molecular structure of liquid water to generate natural and flowing water mists through a high frequency resonance of a ceramic atomization piece, without heating or adding any chemical reagents. Compared with a heating atomization method, the energy is saved 90%. Besides, a large quantity of negative ions will be released during the atomization process, and generate an electrostatic reaction with smokes and dusts floating in the air to produce precipitates thereof. Meanwhile, harmful substances such as formaldehyde, carbon monoxide, bacteria, etc. can be effectively removed so that air is purified and the occurrence of diseases is reduced. A traditional mesh-type ultrasonic atomization piece is mainly composed of a piezoelectric ceramic sheet, a stainless steel metal sheet with a large number of micrometer-sized apertures in the circle center area, a conductive wire welded on one electrode of the piezoelectric ceramic sheet and another conductive wire welded on the stainless steel sheet. A mesh-type atomization piece based on a Flexible Printed Circuit (FPC) is made by bonding the flexible printed circuit and a solder paste or adhesive, etc. with the piezoelectric ceramic sheet. Compared with the traditional mesh-type ultrasonic atomization piece, the production cost of the mesh-type atomization piece based on the flexible printed circuit is lower.

However, in the product detection of the ultrasonic atomization piece made by bonding the flexible printed circuit and the solder paste or adhesive with the piezoelectric ceramic sheet, it was found that the consistency of the product was extremely poor, and the pass rate was less than 50%; besides, the energy conversion efficiency of the PolyimideFilm is low during the atomization process.

Therefore, the prior art is a lack of a manufacturing technology for the atomization piece to overcome the above-mentioned disadvantages.

### SUMMARY

The technical problem solved by the present disclosure is to provide a manufacturing process for ultrasonic atomization piece with the advantages of high product qualification rate, good consistency and high energy conversion efficiency.

In order to solve the above-mentioned technical problems, a manufacturing process for ultrasonic atomization piece provided by the embodiment of the present disclosure, comprises:
S1. cutting a press-thermosetting conductive adhesive film into a shape matched with a piezoelectric ceramic sheet;
S2. placing the press-thermosetting conductive adhesive film on a composite plate, wherein the composite plate includes a substrate and a conductive layer, the press-thermosetting conductive adhesive film is placed on the conductive layer, and the substrate is a polymer film;
S3. placing the piezoelectric ceramic sheet on the press-thermosetting conductive adhesive film;
S4. pressing the piezoelectric ceramic sheet and the composite plate in S3 together by a press machine.

In the above technical solution, furthermore, after S4, the manufacturing process further comprises:
S5. using a laser machine for forming atomizing apertures on the substrate of the composite plate of the pressed product obtained in S4.

In the above technical solution, furthermore, the composite plate is a flexible printed circuit (FPC), the substrate is a PolyimideFilm, and the conductive layer is a copper foil.

In the above technical solution, furthermore, the manufacturing process further comprises: S0. cutting the flexible printed circuit so that the substrate of the flexible printed circuit includes a circular portion capable of covering a central cavity of the piezoelectric ceramic sheet, and a tail portion connected to the circular portion; and the conductive layer includes an annular portion and a tail portion connected to the annular portion.

In the above technical solution, furthermore, the laser machine is used for forming the atomizing apertures on the circular portion of the substrate in S0.

In the above technical solution, furthermore, after S4, the manufacturing process further comprises:
S5. using the laser machine for forming the atomizing apertures on the circular portion of the substrate of the pressed product obtained in S4.

In the above technical solution, furthermore, the circular portion of the substrate is provided with an arc-shaped boss protruding towards the piezoelectric ceramic sheet, and the arc-shaped protrusion is provided with the atomizing apertures.

In the above technical solution, furthermore, the manufacturing process further comprises:
S6. energizing and detecting the product obtained in S5 to obtain a qualified product.

In the above technical solution, furthermore, in S4, the product is pressed by the press machine with a pressure of 6 to 15 MPa while being heated to 80 to 150°C, for 100 to 300 seconds continuously.

In the above technical solution, furthermore, in step S4, silicone gaskets are firstly placed on the upper and lower sides of a combination of the piezoelectric ceramic sheet and the composite plate obtained in S3, and then are pressed together.

Compared with the prior art, the technical solutions of the embodiments according to the present disclosure have the following beneficial effects:

The embodiment of the present disclosure provides a manufacturing process for ultrasonic atomization piece, wherein the press-thermosetting conductive adhesive film is used for connecting the piezoelectric ceramic sheet and the composite plate. The piezoelectric ceramic sheet and the composite plate are pressed together by a press machine, which is beneficial to tighten the substrate of the composite plate to generate a drumhead effect, thus the energy conversion efficiency of the atomization sheet is higher. Moreover, the press-thermosetting conductive adhesive can be cured in a short time under high pressures and heating and has an excellent adhesion. Meanwhile, since the press-thermosetting conductive adhesive is a thin film material, which has an excellent plasticity and can be easily cut into various shapes. The flatness of the material is excellent, so that it has excellent mass production consistency, which can avoid the disadvantage of poor product adhesion consistency caused by uneven coatings of the traditional solder paste and liquid adhesive.

### BRIEF DESCRIPTION OF THE DRAWINGS

Fig. 1 is a flow chart of a manufacturing process for ultrasonic atomization piece according to an embodiment of the present disclosure.
Fig. 2 is a schematic view of the pressed ultrasonic atomization piece prepared in the embodiment of the present disclosure.
Fig. 3 is a schematic structural view of the ultrasonic atomization piece according to an embodiment of the present disclosure.
Fig. 4 is a schematic view of an oscillating waveform transmission of the PolyimideFilm in a tense state.
Fig. 5 is a schematic view of a waveform scattering transmission caused by a copper foil in a wrinkled state.

Reference numbers:
flexible printed circuit (FPC) 1; PolyimideFilm 11; copper foil 12; press-thermosetting conductive adhesive film 2; piezoelectric ceramic sheet 3; atomizing apertures 4; silicone rubber gasket 5.

### DETAILED DESCRIPTION

In order to make the above-mentioned objectives, features and beneficial effects of the disclosure more obvious and understandable, the specific embodiments of the present disclosure will be described in detail with reference to the accompanying drawings hereafter. Apparently, the described embodiments are part of the embodiments of the present disclosure, rather than all of the embodiments. Based on the embodiments in the present disclosure, all other embodiments obtained by those of ordinary skill in the art without creative work shall fall within the protective scope of the present disclosure.

In the description of the present disclosure, it should be noted that the terms "center", "upper", "lower", "left", "right", "vertical", "horizontal", "inner", "outside" , etc. indicating the direction or position relationship are based on the direction or position relationship shown in the drawings, and those terms are just convenient to describe the disclosure and to simplify the description, but not to indicate or imply that the device or the component must have a specific direction, or have been constructed and operated in a specific direction. Therefore, it should not be interpreted as limiting to the present application. In addition, the purpose of the terms "first" and "second" is barely for description, but not to be interpreted as indicating or implying relative importance or implicitly indicating the number of indicated technical features.

In the present disclosure, it should be noted that, unless otherwise expressly provided and defined herein, the terms "arrange", "connect", "connect to", etc. should be interpreted broadly, for example, may be fixedly connected, detachably connected, or integrally connected; may be mechanically connected, or electrically connected; may be directly connected, or may be indirectly connected through an intermediate medium, and may be internally connected between two elements. The specific meanings of the above terms in the present application can be understood according to specific cases by those skilled in the art.

### Embodiment 1

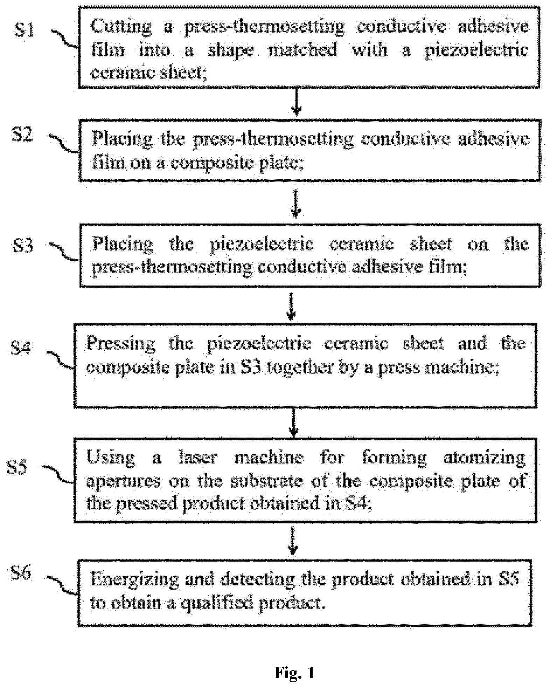

As shown in Fig. 1, a manufacturing process for ultrasonic atomization piece according to an embodiment of the present disclosure comprises:
S1: Cutting a press-thermosetting conductive adhesive film 2 into a shape matched with a piezoelectric ceramic sheet 3.

The piezoelectric ceramic sheet 3 is annular, and the press-thermosetting conductive adhesive film 2 is cut into an annular shape having the same size as that of the piezoelectric ceramic sheet 3.

In some embodiments, the size of the press-thermosetting conductive adhesive film 2 may be slightly smaller or slightly larger than that of the piezoelectric ceramic sheet 3.

S2: Placing the press-thermosetting conductive adhesive film 2 on a composite plate; wherein the composite plate includes a substrate and a conductive layer, the press-thermosetting conductive adhesive film 2 is placed on the conductive layer, and the substrate is a polymer film.

Specifically, the substrate includes a circular portion capable of covering a central cavity of the piezoelectric ceramic sheet 3, the conductive layer includes an annular portion, and the circular portion of the substrate is connected to the annular portion of the conductive layer.

In some embodiments, the composite plate is a flexible printed circuit (FPC) 1, the substrate is a PolyimideFilm 11, and the conductive layer is a copper foil 12. In other embodiments, the substrate of the composite plate is a PolyimideFilm 11, and the conductive layer is a stainless steel sheet.

S3. Placing the piezoelectric ceramic sheet 3 on the press-thermosetting conductive adhesive film 2.

It should be noted that the piezoelectric ceramic sheet 3 should be aligned with the press-thermosetting conductive film 2, that is, the centers should be overlapped.

S4. Pressing the piezoelectric ceramic sheet 3 and the composite plate in S3 together by a press machine.

The product is pressed by the press machine with a pressure of 6 to 15 MPa while being heated to 80 to 150 °C, for 100 to 300 seconds continuously. Most preferably, the pressure of the press machine is 10MPa, the heating temperature is 125 °C, and the duration is 200 seconds.

The best pressure is 10MPa, which will not cause damages due to excessive pressures, and will not cause insufficient compression due to low pressures. The best heating temperature is 125 °C, so the press-thermosetting conductive adhesive film will not melt excessively because of the high temperature, and the temperature will not be too low to achieve the bonding purpose. The best continuous pressing duration is 200 seconds, which can prevent the ultrasonic atomization piece from damaging due to excessively long time, meanwhile, the insufficient compression will not occurred due to short pressing time.

In some embodiments, red silicone gaskets 5 are firstly placed on upper and lower sides of a combination of the piezoelectric ceramic sheet 3 and the composite plate, and then are pressed together.

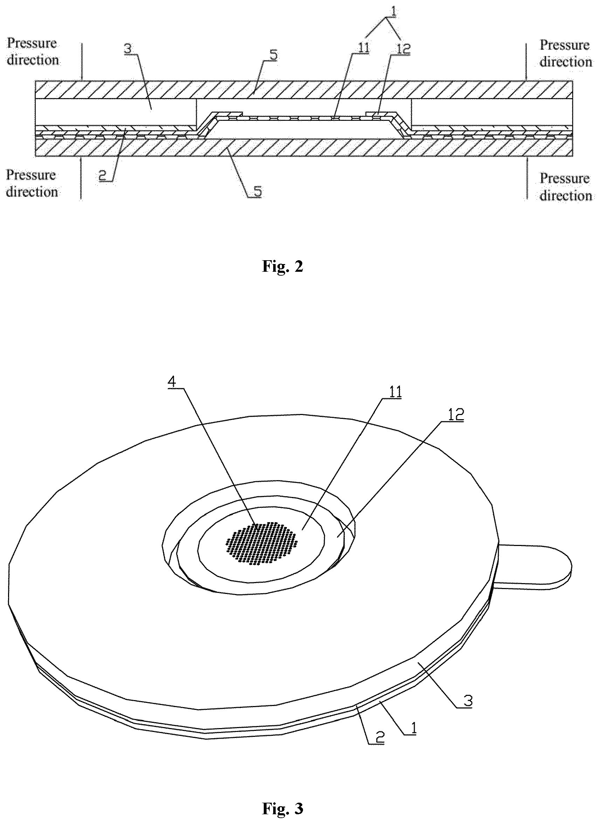

As shown in Fig. 2, red silicone rubber gaskets 5 of a certain thickness are placed on a front side and a back side of the stacked ultrasonic atomization piece, and then are put into a hot press machine together for pressing. During the pressing process, the red silicone rubber gaskets 5 will make parts of soft material deformed, for example, the copper foil 12 and PolyimideFilm 11 of the flexible printed circuit 1. The piezoelectric ceramic sheet 3 will not produce deformation in case of uniform force, and a weak portion of the flexible printed circuit 1 will produce plastic deformation. Finally, a center position of the flexible printed circuit 1 will produce a natural bump due to the symmetrical pressure, and a height of the bump is just located near a center position of the thickness of the piezoelectric ceramic sheet 3. In addition, during a stretching deformation process, the PolyimideFilm 11 at the center position is tightened to generate a drumhead effect, and there is no obvious stress pulling point.

In some embodiments, during the pressing process, an arc-shaped boss protruding towards the piezoelectric ceramic sheet 3 is formed on the circular portion of the substrate, and the arc-shaped boss is provided with atomizing apertures 4.

S5. Using a laser machine for forming atomizing apertures 4 on the substrate of the pressed product obtained in S4.

An inner diameter of the atomizing aperture 4 at a side close to the piezoelectric ceramic sheet 3 is smaller than an inner diameter at a side far away from the piezoelectric ceramic sheet 3. The atomizing aperture 4 has a conical structure, with this design, the more the liquid moves towards the upper surface of the composite plate, the greater the squeezing force the liquid is received, and thus the liquid is easier to pass through the atomizing apertures 4, thereby easily forming water mists.

It should be note that, during the hot pressing process, since the PolyimideFilm 11 of the flexible printed circuit 1 will be tightened to produce a tension, and the flexible printed circuit 1 itself is also subjected to a stress caused by the deformation; thus in order to avoid tearing of drilled the atomizing apertures 4 due to being pulled during the pressing process, the drilling process should be performed after the pressing process.

Specifically, a diameter of an upper portion of the atomization aperture 4 is 2 µm to 8 µm, and a diameter of a lower portion is 20 µm to 60 µm. The aperture diameter of the atomizing aperture 4 can directly affect droplet particles of the water mists, and the atomization effect can be better with the above dimension design.

S6. Energizing and detecting the product obtained in S5 to obtain a qualified product. The structure of the product is shown in Fig. 2 and Fig. 3.

In the prior art, an ultrasonic atomization piece is mainly composed of a piezoelectric ceramic sheet, a stainless steel metal sheet with a large number of micrometer-sized apertures in the circle center area, a conductive wire welded on one electrode of the piezoelectric ceramic sheet and another conductive wire welded on the stainless steel sheet. The piezoelectric ceramic sheet is connected to the stainless steel metal sheet through an adhesive. However, the stainless steel metal sheet and adhesives have many disadvantages, so the present disclosure is determined to solve the above problems and begins to try to utilize the flexible printed circuit material instead of the stainless steel metal sheet.

When the PolyimideFilm 11 at the center of the flexible printed circuit 1 is as flat as possible, the energy conversion efficiency of the atomization piece is the highest, and the corresponding mist-exit amount is at the maximum state. However, the physical characteristics of the flexible printed circuit 1 limit that the flatness thereof cannot be well controlled.

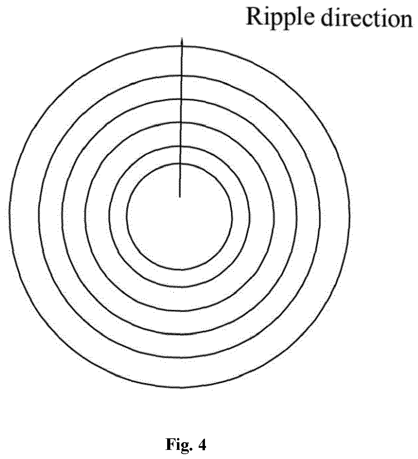

In further test, it was found that when the PolyimideFilm 11 at the center position of the flexible printed circuit 1 is in a tense state, the flatness of the PolyimideFilm 11 is the best and the energy conversion efficiency of the atomization piece has been further improved, the benign benefits resulting from this situation are called the drumhead effect. A drum can emit sounds, which is mainly because a drum head is in a tense state, when the drum head is hit by an external force, an membrane of the drum head will vibrate repeatedly, thus to produce sound waves. Similarly, when the PolyimideFilm 11 at the center of the flexible printed circuit 1 is in the tense state, high-frequency oscillations transmitted from the piezoelectric ceramic sheet 3 will act on the PolyimideFilm 11 at the central position through the copper foil 12. In this case, the PolyimideFilm 11 will produce repeated oscillations similar to those of the drum head; besides, the waveforms are gradually transferred from circumferences to the center position and a maximum amplitude is generated at the circle center. The specific waveform transmission view is shown in Fig. 4. When the film is oscillating, the small apertures of the ultrasonic atomization piece will regularly produce motions perpendicular to the atomization piece gradually from the circumferences to the center position, thereby squeezing and spraying the liquid to produce mists.

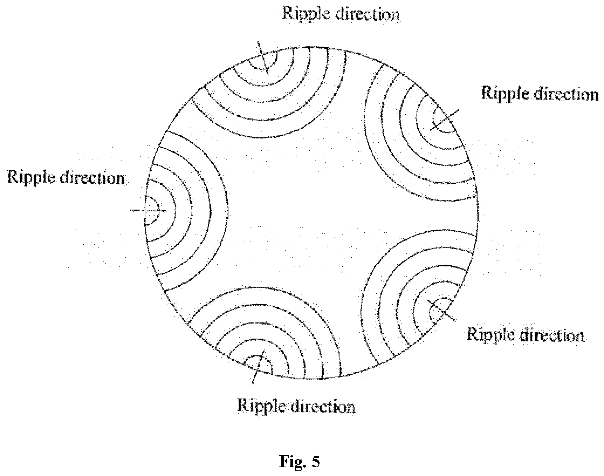

In further test, it was found that when the PolyimideFilm 11 at the center position of the flexible printed circuit 1 is not in the tense state, the high-frequency oscillations generated by the piezoelectric ceramic sheet 3 will be absorbed by the PolyimideFilm 11, and the generated amplitude thereof is not enough to drive the PolyimideFilm 11 to oscillate regularly. It was further found that, even if the PolyimideFilm 11 is in the tense state, since the wrinkles formed on the circumferences of the copper foil 12, the efficiency will also be reduced. The reason for the efficiency reduction is due to the fact that a scattering waveform transmission is formed at the wrinkles when the wrinkles on the circumferences of the copper foil 12 transmit the high-frequency oscillations formed by the ultrasonic waves. As a result, the oscillation amplitude of the film is reduced, and the specific waveform transmission view is shown in Fig. 5.

In summary, it was found that wrinkles are easily formed on the copper foil 12 of the ultrasonic atomization piece that is made by bonding the flexible printed circuit 1 and the solder paste or adhesive with the piezoelectric ceramic sheet 3. Besides, the PolyimideFilm 11 is not easily kept in a tense state; and the stability of the product production is poor.

In this regard, the manufacturing process is changed from the original bonding and post-thermosetting process to the hot pressing process. To adapt to the process change, the bonding material is also replaced from the original solder paste or thermosetting adhesive to the press-thermosetting adhesive film, which can be cured in a short time under high pressure and heating and has excellent adhesion. The press-thermosetting conductive adhesive film is a thin film material with excellent plasticity and can be easily cut into various shapes. The flatness of the material itself is very excellent, so it has excellent mass production consistency, which can avoid the disadvantage of poor product adhesion consistency caused by uneven coating of the traditional solder paste and liquid adhesive. The change of the bonding material has also caused the corresponding equipment to be updated, and the original hot-air welding equipment is updated to a hot press machine. The hot press machine applies extreme pressures to both sides of the stacked ultrasonic atomization piece and heats at the same time, so the bonding material is cured in a short time to form an excellent bonding strength. Meanwhile, the auxiliary red silicone gaskets are added during the pressing process in order that the PolyimideFilm 11 at the center position of the ultrasonic atomization piece is in the tense state. Thus the above-mentioned problem has been solved.

Furthermore, in the test of the product, it was further found that the poor consistency of the resonant frequency of the atomization piece has been solved after the hot pressing process is utilized. In the traditional process, due to various discrete errors such as uneven coating of the liquid adhesives and inconsistent surface tension parameters of the materials, the resonance frequencies of the final products are inconsistent during the working process, thus each product needs to be compensated for the corresponding working frequency, resulting in that the cost of the drive circuit is very high. In this case, the failure rate is also relatively high. However, after the new process is utilized, since the consistency of the adhesive and the consistency of the tension of the material being pressed are excellent, so that the consistency of the resonance frequencies of the finished products has been solved, and the resonance frequency of the products is equal to the resonance frequency of the piezoelectric ceramic, thus the drive circuit has been greatly simplified, which significantly reduces the failure rate of the circuit. Since each product does not need to be compensated for the working frequency any longer, the cost of the drive circuit is effectively reduced.

The manufacturing process for ultrasonic atomization piece provided by the present disclosure has the following beneficial effects:
1. The process of the present disclosure can achieve large-scale mass production, the consistency and controllability of the technical parameters of various equipments and materials are high, therefore better product consistency can be obtained during the manufacturing process, and the defective products caused by various discrete errors based on the liquid adhesive adhesion in the past have been solved.
2. The consistency of the mist-exiting amount based on the flexible printed circuit in the past has been solved, and the working efficiency of the flexible printed circuit has been further improved.
3. The present disclosure has simplified the process flows and can be applied to mass production.
4. The hot pressing processes of the flexible printed circuit, the thermosetting conductive adhesive film and the piezoelectric ceramic sheet according to the present disclosure can easily utilize the automatic processes; besides, the process is applied into the FPC production process, which can reasonably utilize the existing matured technology production line to manufacture products.
5. The process of the present disclosure can be suitable for FPC full-page operation when applied into the FPC production lines, therefore the work efficiency has been improved.
6. The ultrasonic atomization pieces produced by the present disclosure can greatly shorten the supply chains, the FPC manufacturers can provide all manufacturing processes except for drilling apertures, thus to reduce capital input of the project.

### Embodiment 2

Compared with Embodiment 1, the manufacturing process for ultrasonic atomization piece provided in Embodiment 2, before S1, further comprises: S0. cutting the flexible printed circuit 1 so that the substrate of the flexible printed circuit 1 includes a circular portion capable of covering a central cavity of the piezoelectric ceramic sheet 3, and a tail portion connected to the circular portion; and the conductive layer includes an annular portion and a tail portion connected to the annular portion.

The flexible printed circuits 1 can be directly purchased, and then the substrates and conductive layers of the flexible printed circuits 1 are processed to form into the shapes shown in Fig. 2 and 3.

In the step S0, a laser machine can be used for forming the atomizing apertures 4 on the circular portion of the substrate; or the laser machine can be used for forming the atomizing apertures 4 on the substrate of the pressed product.

Although the present disclosure has been described in the above, the present disclosure is not limited to those. Anyone skilled in the art can make various changes and modifications without departing from the spirit and scope of the present disclosure. Therefore, the protective scope of the present disclosure is subject to the protective scope in claims.

## Claims

1. A manufacturing process for ultrasonic atomization piece, comprising:
S1. cutting a press-thermosetting conductive adhesive film into a shape matched with a piezoelectric ceramic sheet;
S2. placing the press-thermosetting conductive adhesive film on a composite plate, wherein the composite plate includes a substrate and a conductive layer, the press-thermosetting conductive adhesive film is placed on the conductive layer, and the substrate is a polymer film;
S3. placing the piezoelectric ceramic sheet on the press-thermosetting conductive adhesive film;
S4. pressing the piezoelectric ceramic sheet and the composite plate in S3 together by a press machine.

2. The manufacturing process for ultrasonic atomization piece according to claim 1, after S4, further comprising:
S5. using a laser machine for forming atomizing apertures on the substrate of the composite plate of the pressed product obtained in S4.

3. The manufacturing process for ultrasonic atomization piece according to claim 1, wherein the composite plate is a flexible printed circuit (FPC), the substrate is a PolyimideFilm, and the conductive layer is a copper foil.

4. The manufacturing process for ultrasonic atomization piece according to claim 3, further comprising:
S0. cutting the flexible printed circuit so that the substrate of the flexible printed circuit includes a circular portion capable of covering a central cavity of the piezoelectric ceramic sheet, and a tail portion connected to the circular portion; and the conductive layer includes an annular portion and a tail portion connected to the annular portion.

5. The manufacturing process for ultrasonic atomization piece according to claim 4, wherein a laser machine is used for forming the atomizing apertures on the circular portion of the substrate in S0.

6. The manufacturing process for ultrasonic atomization piece according to claim 4, after S4, further comprising:
S5. using a laser machine for forming the atomizing apertures on the circular portion of the substrate of the pressed product obtained in S4.

7. The manufacturing process for ultrasonic atomization piece according to claim 4, wherein the circular portion of the substrate is provided with an arc-shaped boss protruding towards the piezoelectric ceramic sheet, and the arc-shaped protrusion is provided with the atomizing apertures.

8. The manufacturing process for ultrasonic atomization piece according to claim 2, further comprising:
S6. energizing and detecting the product obtained in S5 to obtain a qualified product.

9. The manufacturing process for ultrasonic atomization piece according to claim 1, wherein in S4, the product is pressed by the press machine with a pressure of 6 to 15 MPa while being heated to 80 to 150 °C, for 100 to 300 seconds continuously.

10. The manufacturing process of ultrasonic atomization piece according to claim 1, wherein in S4, silicone gaskets are firstly placed on upper and lower sides of a combination of the piezoelectric ceramic sheet and the composite plate obtained in S3, and then are pressed together.

## Amended claims

### Amended claims under Art. 19.1 PCT

1. A manufacturing process for ultrasonic atomization piece, comprising:
S1. cutting a press-thermosetting conductive adhesive film into a shape matched with a piezoelectric ceramic sheet;
S2. placing the press-thermosetting conductive adhesive film on a composite plate, wherein the composite plate is a flexible printed circuit (FPC) which includes a substrate and a conductive layer, the press-thermosetting conductive adhesive film is placed on the conductive layer, the substrate is a polymer film, the substrate is a PolyimideFilm, and the conductive layer is a copper foil;
S3. placing the piezoelectric ceramic sheet on the press-thermosetting conductive adhesive film;
S4. pressing the piezoelectric ceramic sheet and the composite plate in S3 together by a press machine.

2. The manufacturing process for ultrasonic atomization piece according to claim 1, after S4, further comprising:
S5. using a laser machine for forming atomizing apertures on the substrate of the composite plate of the pressed product obtained in S4.

3. The manufacturing process for ultrasonic atomization piece according to claim 1, further comprising:
S0. cutting the flexible printed circuit so that the substrate of the flexible printed circuit includes a circular portion capable of covering a central cavity of the piezoelectric ceramic sheet, and a tail portion connected to the circular portion; and the conductive layer includes an annular portion and a tail portion connected to the annular portion.

4. The manufacturing process for ultrasonic atomization piece according to claim 3, wherein a laser machine is used for forming the atomizing apertures on the circular portion of the substrate in S0.

5. The manufacturing process for ultrasonic atomization piece according to claim 3, after S4, further comprising:
S5. using a laser machine for forming the atomizing apertures on the circular portion of the substrate of the pressed product obtained in S4.

6. The manufacturing process for ultrasonic atomization piece according to claim 3, wherein the circular portion of the substrate is provided with an arc-shaped boss protruding towards the piezoelectric ceramic sheet, and the arc-shaped protrusion is provided with the atomizing apertures.

7. The manufacturing process for ultrasonic atomization piece according to claim 2, further comprising:
S6. energizing and detecting the product obtained in S5 to obtain a qualified product.

8. The manufacturing process for ultrasonic atomization piece according to claim 1, wherein in S4, the product is pressed by the press machine with a pressure of 6 to 15 MPa while being heated to 80 to 150 °C, for 100 to 300 seconds continuously.

9. The manufacturing process of ultrasonic atomization piece according to claim 1, wherein in S4, silicone gaskets are firstly placed on upper and lower sides of a combination of the piezoelectric ceramic sheet and the composite plate obtained in S3, and then are pressed together.
